# EUROPEAN PATENT SPECIFICATION

(11) **EP 0 721 607 B1**
(45) Date of publication and mention of the grant of the patent: **11.10.2000**
(21) Application number: 94929905.1
(22) Date of filing: 27.09.1994
(51) Int. Cl.: G03F 7/09, B41N 3/03, C09D 143/02

(54) **PROCESS FOR IMPROVING THE HYDROPHILICITY OF THE SUBSTRATE FOR A LITHOGRAPHIC PRINTING PLATE BY TREATMENT WITH POLYVINYL PHOSPHONIC ACID**
VERFAHREN ZUR VERBESSERUNG DER HYDROPHILIE DES SUBSTRATES FÜR EINE LITHOGRAPHISCHE DRUCKPLATTE DURCH BEHANDLUNG MIT POLYVINYLPHOSPHONSÄURE
PROCEDE D'AMELIORATION DU CARACTERE HYDROPHILE D'UN SUBSTRAT POUR DES PLAQUES LITHOGRAPHIQUES PAR TRAITEMENT A L'ACIDE POLYVINYLE PHOSPHONIQUE

(30) Priority: 29.09.1993 US 128911
(43) Date of publication of application: 17.07.1996
(73) Proprietor: Bayer Corporation, Pittsburgh, PA 15219-2502 (US)
(72) Inventor: LOVELAND, Allen, W., Scotch Plains, NJ 07076 (US); WANAT, Stanley, F., Belle Mead, NJ 08502 (US); Major S. DHILLON, Belle Mead New Jersey 08502 (US); SPRINTSCHNIK, Gerhard, Washington, NJ 07882 (US); KING, Dennis, A., North Plainfield, New Jersey 07063 (US)
(74) Representative: Zounek, Nikolai, Dipl.-Ing.
(86) International application number: US9410939
(87) International publication number: WO9509384

(56) References cited:
- EP-A- 0 089 510
- DE-C- 4 203 010
- US-A- 3 276 868
- US-A- 4 227 765
- US-A- 4 578 156
- US-A- 4 689 272

## Description

### FIELD OF THE INVENTION

This invention discloses a process to prepare a lithographic printing plate having an improved hydrophilicity.

### BACKGROUND OF THE INVENTION

The art of lithography is well known and is practiced commercially in several fields including, for example, the electronic industry, newspaper industry, magazines, and the like. The field of lithography has been extensively written and commented upon in several books and articles. See, for example, *Kirk-Othmer*, *Encyclopedia of Chemical Technology*, Vol. 19, p. 140, John Wiley & Sons (1982); *ibid*, Vol. 20, p. 161 (1982); and *Encyclopedia of Polymer Science and Engineering*, Vol. 13, p. 373, John Wiley & Sons (1988).

A typical lithographic printing plate comprises a substrate surface, typically made of aluminum, silicon and the like, with a photosensitive layer on top. When aluminum is the substrate material, generally the top of aluminum is anodically oxidized prior to deposition of the photosensitive layer. When printing images are photomechanically produced on such a printing plate, the applied photosensitive layers can penetrate too deeply into the porous oxide layer. This can result in inked areas of the non-imaged portion of the plate. This problem is referred to as "toning" in the industry.

It has been found in the past that improving the hdyrophilicity of the non-image areas generally tends to reduce this toning problem. Generally the hydrophilicity is improved by reaction with a protective conditioning agent (also called passivating or sealing agent). These conditioning materials react with the surface oxide to seal the porous layer and render it more hydrophilic. Commonly used conditioners or sealers are the silicates, carboxylic acids or phosphonic acids which form the oxo-silicate, oxo-carboxylate or oxo-phosphonate, respectively. Polymer analogs are preferred since the surface hydrophilicity is enhanced by those unreacted groups on the polymer backbone which cover the surface of the treated substrate surface.

U.S. Patent No. 4,153,461 discloses the use of polyvinyl phosphonic acid ("PVPA") as a conditioning agent. Example 1 in that U.S. Patent describes the use of an aqueous solution of PVPA to treat the surface of oxidized aluminum.

While the use of PVPA improves the quality of the printing plates to some extent, the problem of sensitivity to background toning still remains. Thus, even plates that have undergone the PVPA treatment are known to have the problem, albeit to a less extent.

Thus, it would be desirable to have a process whereby good quality lithographic plates can be produced without the above toning problem.

It would also be desirable to have a process whereby the hydrophilicity of the non-image areas in the surface of printing plate substrates can be improved, thus improving the quality of images printed therefrom.

### SUMMARY OF THE INVENTION

The treatment of lithographic printing plate substrate surface with a solution of polyvinyl phosphonic acid that has pH in the range about 2.5 to 6.6 surprisingly improves the hydrophilicity of the non-image areas in the surface and also eliminates the background toning problem, thus resulting in printed images with excellent contrast, sharpness and brightness. At the same time, surfaces treated with PVPA solution alone (which is generally at pH=2.2), or with completely neutralized PVPA under the same conditions results in images with background toning still present.

### DESCRIPTION OF THE PREFERRED EMBODIMENTS

In one embodiment, the present invention discloses a process to prepare a lithographic printing plate, sequentially comprising:
(a) providing a substrate made of a suitable metal;
(b) preparing a polyvinyl phosphonic acid solution by partially neutralizing a solution of polyvinyl phosphonic acid in a solvent comprising water and an aqueous base
(c) hydrophilizing the substrate by a step consisting essentially of bringing said substrate in contact with the solution of the partially neutralized polyvinyl phosphonic acid in a solvent comprising water, at a temperature ranging from ambient to about 100 °C for about 5-20 seconds, wherein said polyvinyl phosphonic acid solution is maintained at a pH of about 2.5 to 6.6;
(d) applying a photosensitive layer;
(e) exposing said photosensitive layer to suitable actinic radiation; and
(f) developing said exposed layer in a suitable developer.

Such a process advantageously also improves the quality of the printed images prepared from the printing plate. Furthermore, the inventive process may be used on oxidized surfaces as well as those that are not oxidized.

In a further embodiment, the present invention refers to a general process to a process to prepare a lithographic printing plate, sequentially comprising:
(a) providing a metal substrate;
(b) hydrophilizing the metal substrate by a step consisting essentially of bringing said metal substrate in contact with solution of polyvinyl phosphonic acid in a solvent comprising water, at a temperature ranging from ambient to about 100°C for about 5-20 seconds, wherein said polyvinyl phosphonic acid solution has been partially neutralized with an aqueous base and is maintained at a pH of about 2.5 to 6.6;
(c) applying a photosensitive layer;
(d) exposing said photosensitive layer to a suitable actinic radiation; and
(e) developing said exposed layer in a suitable developer.

Typical alkaline degreasing agents include: hot aqueous solutions containing alkalis such as potassium hydroxide, sodium hydroxide, trisodium phosphate, sodium silicate, and aqueous alkalis mixed with surfactants. Solvent type degreasers such as trichloroethylene, 1,1,1 trichloroethane, perchloroethylene can be used but are less popular because of increasing environmental and health considerations.

Solvent degreasing is done by immersion, spray or vapor washing with the listed agents. Preferably the substrate comprises aluminum, although the inventive process may conceivably be used with other substrate materials also. The substrate may be in the form of a plate, coil and the like. Generally, the aluminum substrate surface is cleaned and degreased with suitable reagents such as, for example, alkaline reagents like aqueous sodium hydroxide solution, aqueous potassium hydroxide solution and the like.

The metal surface may be smooth or roughened. Conventional surface roughening (graining) techniques include but are not restricted to chemical etching in alkaline or acid solutions, graining by dry abrasion with metal brushes and wet graining with aqueous slurries of abrasive particles, ball graining with metal shot and electrochemical graining whereby controlled pitting of the metal surface is achieved in aqueous electrolyte media under the influence of an electrical current. The electrolyte media may be acidic or basic, organic or inorganic; an inorganic acidic media, however, is preferred. The surface topography and roughness varies with each of these graining processes. Generally a mean roughness of about 0.2 to about 1 Ra is produced in a typical graining process. Ra is a measurement of average roughness of the surface and is defined as the arithmetic average of all departures of the roughness profile from the center line within the desired evaluation length.

Substrates may be optionally etched in aqueous caustic or acid baths to remove surface deposits generated by graining and aerial oxide formed on the labile aluminum surface. Etching is followed by rinsing. Steps following surface roughening are preferably, though not exclusively, done with the metal kept wet.

After roughening and etching, the metal may be optionally anodized ("oxidized") to improve surface hardness and wear resistance of the final product. Anodization is typically carried out in aqueous inorganic electrolyte baths where the aluminum surface acts as the anode in an electrochemical process. Preferred electrolytes are the strong acids such as sulfuric and phosphoric. Organic acids and mixtures may additionally be used to impart specific properties to the final product. Anodization is generally performed at temperatures between ambient to about 100°C (212°F), as is well known to those skilled in the art. Generally an oxide weight of about 0.25-3.5 gram/m² is built on the surface in a typical lithographic plate process.

The anodized plate is then rendered more hydrophilic by using the inventive conditioning process. The process comprises using a conditioning reagent comprising PVPA solution partially neutralized to, and maintained at, a pH of about 2.5 to 6.6. Preferably the pH is about 2.5 to 6, while typically the pH is about 2.5 to 5. This PVPA solution is generally an aqueous solution although suitable water-miscible solvents such as alcohol, acetone and the like, may be added to the water solution if so desired. The desired pH is obtained by partially neutralizing a solution of PVPA in water with an aqueous base. Examples of bases useful for neutralization include sodium hydroxide, potassium hydroxide, calcium hydroxide, ammonium hydroxide, tetramethylammonium hydroxide and tetrabutylammonium hydroxide. Preferred bases are sodium hydroxide and potassium hydroxide. Generally, for neutralization, a solution of the base in water is prepared which is then added to the PVPA solution while monitoring the pH at the same time. When the pH reaches the desired level, addition of base is stopped. The inventive conditioning solution thus contains partially neutralized PVPA, which refers to the fact that part of the PVPA exists as a salt with the base. When sodium hydroxide is used as the neutralizing base, for example, the conditioning solution exists as partial sodium salt of PVPA along with free acid groups.

The inventive conditioning process is generally done at temperatures ranging from ambient to about 100°C (212°F), preferably from about 38 to 93°C (100-200°F) and typically from about 60 to 79°C (140-180°F). The PVPA solution at the desired pH is maintained at this temperature while the plate is treated with the conditioning reagent. The word "treated" refers to processes such as dipping, immersing, spraying and the like, which bring the surface into contact with the conditioning reagent. The conditioning is done for about 0.5-300 seconds generally, for about 1-60 seconds preferably, and for about 5-20 seconds typically. Then it is rinsed with water.

The rinsed plates are then dried with forced hot air, and then coated with a photosensitive layer. Photosensitive layers are made from photosensitive compounds that may be optionally mixed with suitable additives such as, for example, binder resins, photoinitiators, colorants, acid stabilizers, exposure indicators, surfactants and the like, known to those skilled in the art. Photosensitive compounds ("light sensitive compounds") useful in the practice of the invention include, for example, those described, in U.S. Patent Nos. 3,849,392; 3,867,147; 4,157,918, and 4,183,788. Additives that may be used in combination with such light sensitive compounds include those described in U.S. Patent No. 3,679,419.

Photosensitive compounds are of two types: positive and negative working types. Positive types are those where the area of the plate exposed by light radiation through a mask are removed in the development step. In negative types, the exposed areas are hardened and remain after development.

Positive working photosensitive materials suitable in the practice of the invention are iminoquinone diazides, ortho-quinone diazides and the like, which contain sulfonic acid esters of such diazides, prepared by reacting the appropriate sulfonyl chlorides with one or more labile aromatic hydroxyl groups. Preferred are the ortho-quinone diazides containing the above-described sulfonic acid ester groups. These esters undergo a photo Wolff rearrangement whereby loss of nitrogen is followed by a ring contraction and generation of a carboxylic acid which is easily removed using alkaline developing solutions. Several such positive acting compounds are described in, for example, U.S. Patents 3,175,906 and 4,157,918.

Negative type photosensitive materials are generally made by using the photo-labile crosslinking capabilities of oligomeric compounds such as, for example, the diazonium compounds, or the photo-polymerization of reactive monomers, or a combination of both. Several are described, for example, in U.S. Patent 4,157, 918. These are generally free radical polymerizations which are inhibited by oxygen. Oxygen barrier coatings are generally made atop the photosensitive coating to prevent interference from aerial oxygen when using negative photopolymer products. Generally, the photosensitive layer is selected based on the actinic radiation that is going to be used for exposure, as is known to those skilled in the art. While the present invention may be practiced with both positive and negative type photosensitive materials, the present description describes the negative photosensitive layer materials to illustrate the invention. Furthermore, the illustration describes the use of diazonium photosensitive materials. No limitation in the nature or type of photosensitive materials is contemplated thereby. Some diazonium compounds useful for the practice of the invention are described, for example, in U.S. Patent Nos. 3,849,392; 3,867,147; 4,183,788 and 5,200,291.

As mentioned above, the light sensitive compound may optionally be mixed with additives as described above to form a photosensitive coating material, if so desired. For example, acid stabilizers may be used with diazonium compounds; suitable acid stabilizers are generally organic or inorganic acids. Examples include phosphoric, citric, benzoic, m-nitrobenzoic, p-toluenesulfonic, and the like as well as mixtures thereof. Preferably, the acid stabilizer is phosphoric acid. When used, the acid stabilizer is present generally in the amount of from about 0.02 % to about 2 %, and preferably from about 0.05 % to about 1.0 % based on the weight of the composition.

Exposure indicators (or photoimagers) which may be useful in conjunction with the present invention include 4-phenylazodiphenylamine, eosin, azobenzene, Calcozine Fuchsine dyes and Crystal Violet and Methylene Blue dyes. Preferably, the exposure indicator is 4-phenylazodiphenylamine. The exposure indicator, when one is used, is preferably present in the composition in an amount of from about 0.01% to about 0.35% by weight. A more preferred range is from about 0.02% to about 0.30% and, most preferably, the exposure indicator is present in an amount of from about 0.02% to about 0.20%, although the skilled artisan may use more or less as desired.

Colorants useful herein include dyes such as Rhodamine, Calcozine, Victoria Blue and methyl violet, and such pigments as the anthraquinone and phthalocyanine types. Generally, the colorant is present in the form of a pigment dispersion which may comprise a mixture of one or more pigments and/or one or more dyes dispersed in a suitable solvent or mixture of solvents. When a colorant is used, it is preferably present in the composition of this invention in an amount of from about 2.0% to about 35.0% by weight, more preferably from about 5.0% to about 30.0% and most preferably from about 5.0% to about 20% although the skilled artisan may use more or less as desired.

Resin binders may be used in the coating to increase the functional lifetime of the printing plates. If resin binders are desired, suitable binder resins are chosen based upon their compatibility with other coating components, the ability to be cleaned away during the development step in non-image areas of the plate and their resistance to wear on press. Resins with acid end groups are especially desirable since the acid helps stabilize the coatings based upon diazonium compounds and provides alkaline solubility for development.

In order to form a coating composition for the production of the photosensitive layer, the light sensitive compound is coated from a solution in a suitable solvent, wherein the light sensitive compound is present in amounts such that the concentration of the light sensitive compound is generally in the range 10-100% of the total solids in the dried coating upon drying (see below), preferably in the range 30-75%, and typically in the range 40-60%. Suitable solvents for this purpose include water, tetrahydrofuran, butyrolactone, glycol ethers such as propylene glycol monomethyl ether and methyl cellosolve, alcohols such as ethanol and n-propanol, and ketones such as methyl ethyl ketone, or mixtures thereof. Preferably, the solvent comprises a mixture of propylene glycol monomethyl ether and butyrolactone. In general, after the solution is applied to an appropriate substrate by a suitable coating process, the solvent system is evaporated from the coating by a suitable drying process; some insignificant amount of solvent may, however, remain as residue.

The process to coat the light sensitive layer may be a batch or continuous process as is known to those skilled in the art. Some useful coating processes include dip coating, roller coating, slot type coating, spin coating, and the like, which deposit a thin uniform dry photosensitive coating on the surface once the solvents have been driven off. At the end of the coating operation and drying, generally a coating weight of from about 0.5g/m² to about 2.5g/m², preferably from about 0.8 g/m² to about 2.0 g/m² and typically about 1.0 g/m² is obtained.

The thus prepared photographic element is then exposed to suitable actinic radiation through a negative mask so as to yield a solid 5 on a 21 step Stouffer exposure wedge (supplied by Stouffer Graphic Arts Equipment Company, South Bend, Indiana) after development. Generally a radiation in the range of 300-400 nm is employed. The exposed plate is then developed with a suitable developer. Suitable developer may be aqueous developer, or aqueous developer mixed with a suitable organic solvent. An aqueous developer useful in the present invention comprises an aqueous solution containing one or more of the following groups:
(a) a sodium, potassium or lithium salt of octyl, decyl or dodecyl monosulfate;
(b) a sodium, lithium, potassium or ammonium metasilicate salt;
(c) a lithium, potassium, sodium, or ammonium borate salt; (d) an aliphatic dicarboxylic acid, or sodium, potassium or ammonium salt thereof having from 2 to 6 carbon atoms; and
(e) mono-, di-, or tri-sodium, or -potassium phosphate.

Other suitable developers include water, benzoic acid or sodium, lithium and potassium benzoates and the hydroxy substituted analogs thereof as well as those developers described in U. S. Patent No. 4,436,807.

In conventional use, the developed plate is finished with a subtractive finisher such as a hydrophilic polymer. Examples include cold water soluble dextrin and/or polyvinyl pyrrolidone, a nonionic surfactant, a humectant, an inorganic salt and water, as taught by U. S. Patent No. 4,213,887.

For the purpose of improving the press performance of a plate prepared as described above, it is known that baking of the exposed and developed plate can result in an increase in the number of quality impressions over that otherwise obtainable. To properly bake the plate, it may be first treated with a suitable solution designed to prevent loss of hydrophilicity of the background during baking. An example of a suitable solution is disclosed in U. S. Patent No. 4,355,096. The plate prepared as above may then be heat treated by baking at temperature of from about 180°C up to the annealing temperature of the substrate, preferably about 240°C. The effective baking time is inversely proportional to the temperature and averages in the range of from about 2 to about 15 minutes.

In another embodiment, the present invention discloses improved lithographic plates prepared using the conditioning process described above. Such plates have utility in preparing colored sheets with excellent contrast.

The improvement in the hydrophilicity as well as in the quality of printing plates achievable through the process of the instant invention was demonstrated as follows. An aluminum coil (99.5 Al alloy) was cleaned, mechanically roughened, etched and then anodized as described above. The coil was divided into eight sections. Section **1** (control) was conditioned with an unneutralized PVPA solution (pH 2.0) as described in the U.S.patent No. 4,153,461 referred to above. Sections **2** through **6** were conditioned with PVPA solution partially neutralized with NaOH in accordance with the present invention at pH's ranging from 2.9 through 6.6. Section **7** was conditioned with PVPA solution completely neutralized with NaOH solution (pH 7.1). Section **8** was made with a different alloy of aluminum (3103) containing Cu and Mn (98.5% Al alloy), and was conditioned with an inventive partially neutralized PVPA solution with pH 3.8.

Sections **1** to **8** were then coated with a photosensitive layer comprising a suitable negative acting diazonium compound. The diazonium compound used in this particular instance was the polycondensation product of 3-methoxy-4-diazo diphenyl amine sulfate and 4,4'-bismethoxy methyldiphenyl ether, precipitated as mesitylene sulfonate, described in U.S. Patent 4,157,918. It was then exposed to UV light (365 nm) for 30 seconds, using a Teaneck exposure unit (sold by Teaneck Graphics Systems, Teaneck, New Jersey, using a L1250 UV light source from Olec Corporation, Irvine, California). Development was then done with an aqueous developer sold under the trade name ND-143 by Hoechst Celanese Corporation, Printing Products Division, Branchburg, New Jersey.

The sensitivity to background toning was measured by preparing printed images using the eight sections on a printing press, and then measuring the number of sheets ("copies") needed to print cleanly ("clean-out") after application of the dampening rollers to each section. Table 1 lists the number of sheets needed to clean-out. The less the number of sheets needed, the better is the performance of the printing plate. As Table 1 indicates, Sections **1** and **7** would not clean-out even after rolling out >100 copies, while sections **2** through **6** and **8** needed much less (40-50 copies) to clean-out, demonstrating the superiority of the inventive process in improving the hydrophilicity of the non-image areas, the quality of the lithographic plates prepared and the quality of the images printed therefrom.

The following examples are illustrative of the invention but it is understood that the invention is not limited thereto.

### EXAMPLES

In the following Example, coils made of aluminum alloys 1050 and 3103 (supplied by Alcoa Co., Pittsburgh, Pennsylvania) were used. Ambient temperature refers to about 20-30°C.

A coil of Aluminum (Alloy 1050, 99.5% Al alloy) was divided into eight sections (Sections **1** through **7**). Section 1 was A) degreased in a 1.3% NaOH solution at about 57°C (135°F) for about 15 seconds, and then B) mechanically roughened using a 23% silica slurry in water by the action of rotating nylon brushes giving a mean roughness of about 0.45 Ra. The coil was then C) etched in a dilute caustic bath (1.5%) at 54°C (130°F) to brighten the surface followed by D) anodization in 19% H₂SO₄, to yield an oxide weight of 1.4 g/l. The oxide surface was E) conditioned/passivated by spraying the substrate with a 0.2% polyvinyl phosphonic acid solution in water at 71°C (160°F) (pH= 2.2). This section **1** of the web was the control section.

Another section (section **2**) of the coil was treated with the same sequence of process steps A-D described above. At this point the polyvinyl phosphonic acid solution was partially neutralized by the addition of 50% NaOH to pH=2.9.

Another section (section **3**) was similarly treated through process steps A-D followed by treatment with polyvinyl phosphonic acid solution neutralized as above to pH=3.6. Section **4** was neutralized to pH-4.5, section **5** to pH 5.4, and section **6** to pH 6.6.

Section **7** was treated through process steps A-D followed by conditioning with polyvinyl phosphonic acid solution which had been completely neutralized with NaOH to pH= 7.1.

Section **8** was made with a different alloy of Aluminum (3103) containing Cu and Mn (Al∼98.5%). Section **8** was treated through process steps A-D followed by treatment with polyvinyl phosphonic acid solution neutralized as above to pH=3.8.

The test sections **1** through **8** were then coated with a photosensitive coating (a diazo resin which was the polycondensation product of 3-methoxy-4-diazo diphenyl amine sulfate and 4,4'-bismethoxy methyl-diphenyl ether, precipitated as mesitylene sulfonate, described in U.S. Patent 4,157,918, and a modified polyvinylacetal resin described in U.S. Patent 4,940,646) and exposed to U.V. light through a negative mask. The plates were developed in the above-described ND-143 aqueous developer. The sensitivity to background toning was measured by running imaged plates on press in a dry scum cycle test using Kohl-Madden red ink on a Heidelberg printing press. The number of sheets needed to print cleanly was determined after application of the dampening rollers. The following Table shows the results of these experiments.

**Table 1**

| Section | Alloy | pH | # Sheets to Clean-out |
|---|---|---|---|
| 1 | 1050 | 2.2 | >100 |
| 2 | 1050 | 2.9 | 50 |
| 3 | 1050 | 3.6 | 40 |
| 4 | 1050 | 4.5 | 40 |
| 5 | 1050 | 5.4 | 40 |
| 6 | 1050 | 6.5 | 40 |
| 7 | 1050 | 7.1 | >100 |
| 8 | 3103 | 3.8 | 40 |

As Table 1 indicates, Section **1** with no neutralization and Section **7** with complete neutralization, the print sheets would not clean-out even at >100 copies while the other partially neutralized sections cleaned out readily showing an increased hydrophilicity in the non-image areas of the lithographic printing plates.

## Claims

1. A process to prepare a lithographic printing plate, sequentially comprising:
(a) providing a substrate made of a suitable metal;
(b) preparing a polyvinyl phosphonic acid solution by partially neutralizing a solution of polyvinyl phosphonic acid in a solvent comprising water and an aqueous base;
(c) hydrophilizing the substrate by a step consisting essentially of bringing said substrate in contact with the solution of the partially neutralized polyvinyl phosphonic acid in a solvent comprising water, at a temperature ranging from ambient to about 100 °C for about 5-20 seconds, wherein said polyvinyl phosphonic acid solution is maintained at a pH of about 2.5 to 6.6;
(d) applying a photosensitive layer;
(e) exposing said photosensitive layer to suitable actinic radiation; and
(f) developing said exposed layer in a suitable developer.

2. The process as described in claim 1, wherein said substrate is made of aluminum or steel.

3. The process as described in claim 1, wherein said substrate is made of aluminum.

4. The process as described in claim 1, wherein said polyvinyl phosphonic acid solution is maintained at a pH range of about 2.5 to 6.

5. The process as described in claim 1, wherein said polyvinyl phosphonic acid solution is maintained at a pH range of about 2.5 to 5.

6. The process as described in claim 1, wherein said base is selected from the group consisting of sodium hydroxide, potassium hydroxide, ammonium hydroxide, calcium hydroxide and tetramethylammonium hydroxide.

7. The process as described in claim 6, wherein said base is sodium hydroxide.

8. The process as described in claim 1, wherein said contacting is done at a temperature range of about 38 to 93°C (100-200°F).

9. The process as described in claim 1, wherein said contacting is done at a temperature range of about 60 to 79°C (140-180°F).

10. The process as described in claim 1, wherein said photosensitive layer comprises a photosensitive compound of positive type.

11. The process as described in claim 1, wherein said photosensitive layer comprises a photosensitive compound of negative type.

12. The process as described in claim 10, wherein said positive photosensitive compound is a sulfonic acid ester of an ortho-quinone diazide.

13. The process as described in claim 11, wherein said negative photosensitive compound is a diazonium compound.

14. The process as described in claim 13, wherein said diazonium compound is a polycondensation product of 3-methoxy-4-diazo diphenyl amine sulfate and 4,4'-bismethoxy methyl-diphenyl ether, precipitated as mesitylene sulfonate.

15. The process as described in claim 1, wherein said actinic radiation has a wavelength range 300-400 nm.

16. The process as described in claim 1, wherein said developer is an aqueous developer selected from the group consisting of sodium octyl monosulfate, potassium decyl monosulfate, lithium dodecyl monosulfate and combinations thereof.

17. The process as described in claim 1, wherein said metal substrate in step (a) is further roughened on surface.

18. The process as described in claim 17, wherein said roughened substrate is further oxidized.

19. A lithographic printing plate prepared by the process described in claim 1.

20. A process to prepare a lithographic printing plate, sequentially comprising:
(a) providing an aluminum substrate;
(b) hydrophilizing the aluminum substrate by a step consisting essentially of bringing said aluminum substrate in contact with solution of polyvinyl phosphonic acid in a solvent comprising water, at a temperature ranging from ambient to about 100°C for about 5-20 seconds, wherein said polyvinyl phosphonic acid solution has been partially neutralized with an aqueous base and is maintained at a pH of about 2.5 to 6.6;
(c) applying a photosensitive layer;
(d) exposing said photosensitive layer to a suitable actinic radiation; and
(e) developing said exposed layer in a suitable developer.

21. The process as described in claim 20, wherein said aluminum substrate in step (a) is further roughened and then further oxidized.

22. The process as described in claim 20, wherein said photosentitive layer of step (c) comprises a diazonium compound, said actinic radiation of step (d) is in the wavelength range 300-400 nm, and said developer of step (e) is an aqueous developer.

23. A process to prepare a lithographic printing plate, sequentially comprising:
(a) providing a metal substrate;
(b) hydrophilizing the metal substrate by a step consisting essentially of bringing said metal substrate in contact with solution of polyvinyl phosphonic acid in a solvent comprising water, at a temperature ranging from ambient to about 100°C for about 5-20 seconds, wherein said polyvinyl phosphonic acid solution has been partially neutralized with an aqueous base and is maintained at a pH of about 2.5 to 6.6;
(c) applying a photosensitive layer;
(d) exposing said photosensitive layer to a suitable actinic radiation; and
(e) developing said exposed layer in a suitable developer.

24. The process as described in claim 23, wherein said metal substrate is aluminum which has been further roughened and still further oxidized.

## Patentansprüche

1. Verfahren zur Herstellung einer lithographischen Druckplatte, das die aufeinanderfolgenden Schritte umfasst:
(a) Bereitstellen eines Trägers aus einem geeigneten Metall;
(b) Vorbereiten einer Polyvinylphosphonsäure-Lösung durch partielle Neutralisation einer Lösung aus Polyvinylphosphonsäure in einem Lösungsmittel enthaltend Wasser und eine wässrige Base;
(c) Hydrophilieren des Trägers durch Kontaktieren des Trägers mit der Lösung aus partiell neutralisierter Polyvinylphosphonsäure in einem Lösungsmittel, das Wasser enthält, bei einer Temperatur im Bereich der Umgebungstemperatur bis zu 100 °C für 5 bis 20 Sekunden, wobei die Polyvinylphosphonsäure-Lösung auf einem pH-Wert von 2,5 bis 6,6 gehalten wird.
(d) Aufbringen einer fotoempfindlichen Schicht;
(e) Belichten der fotoempfindlichen Schicht mit geeigneter aktinischer Strahlung; und
(f) Entwickeln der belichteten Schicht mit einem geeigneten Entwickler.

2. Verfahren nach Anspruch 1, bei dem der Träger aus Aluminium oder Stahl besteht.

3. Verfahren nach Anspruch 1, bei dem der Träger aus Aluminium besteht.

4. Verfahren nach Anspruch 1, bei dem die Polyvinylphosphonsäure-Lösung bei einem pH-Wert im Bereich von 2,5 bis 6 gehalten wird.

5. Verfahren nach Anspruch 1, bei dem die Polyvinylphosphonsäure-Lösung bei einem pH-Wert im Bereich von 2,5 bis 5 gehalten wird.

6. Verfahren nach Anspruch 1, dadurch gekennzeichnet, dss die Base aus der Gruppe Natriumhydroxid, Kaliumhydroxid, Ammoniumhydroxid, Kalziumhydroxid und Tetramethylammoniumhydroxid ausgewählt wird.

7. Verfahren nach Anspruch 6, dadurch gekennzeichnet, dass die Base Natriumhydroxid ist.

8. Verfahren nach Anspruch 1, dadurch gekennzeichnet, dass das Kontaktieren in einem Temperaturbereich von 38 bis 93 °C (100 bis 200 °F) vorgenommen wird.

9. Verfahren nach Anspruch 1, dadurch gekennzeichnet, dass das Kontaktieren in einem Temperaturbereich von 60 bis 79 °C (140 bis 180 °F) vorgenommen wird.

10. Verfahren nach Anspruch 1, dadurch gekennzeichnet, dass die fotoempfindliche Schicht eine positiv fotoempfindliche Verbindung enthält.

11. Verfahren nach Anspruch 1, dadurch gekennzeichnet, dass die fotoempfindliche Schicht eine negativ fotoempfindliche Verbindung enthält.

12. Verfahren nach Anspruch 10, dadurch gekennzeichnet, dass die positiv fotoempfindliche Verbindung ein Sulfonsäureester eines ortho-Chinondiazids ist.

13. Verfahrennach Anspruch 11, dadurch gekennzeichnet, dass dienegativfotoempfindliche Verbindung eine Diazoverbindung ist.

14. Verfahren nach Anspruch 13, dadurch gekennzeichnet, dass die Diazoverbindung ein Polykondensationsprodukt des 3-Methoxy-4-diazo-diphenylaminsulfats und des 4,4'-Bis-methoxy-methyldiphenylether ist, ausgefällt als Mesitylensulfonat.

15. Verfahren nach Anspruch 1, dadurch gekennzeichnet, dass die aktinische Strahlung einen Wellenlängenbereich von 300 bis 400 nm aufweist.

16. Verfahren nach Anspruch 1, dadurch gekennzeichnet, dass der Entwickler ein wässriger Entwickler ausgewählt aus der Gruppe Natriumoktylmonosulfat, Kaliumdecylmonosulfat, Lithiumdodecylmonosulfat und Kombinationen hiervon, ist.

17. Verfahren nach Anspruch 1, dadurch gekennzeichnet, dass der Metallträger im Schritt (a) an der Oberfläche aufgeraut ist.

18. Verfahren nach Anspruch 17, dadurch gekennzeichnet, dass der aufgeraute Träger oxidiert ist.

19. Lithographische Druckplatte, vorbereitet durch das Verfahren gemäß Anspruch 1.

20. Verfahren zum Vorbereiten einer lithographischen Druckplatte, umfassend aufeinanderfolgende Schritte:
(a) Bereitstellen eines Aluminiumträgers;
(b) Hydrophilieren des Aluminiumträgers durch einen Schritt, der im wesentlichen darin besteht, den Aluminiumträger in Kontakt mit einer Lösung aus Polyphosphonsäure in einem Lösungsmittel, das Wasser enthält, zu bringen bei einer Temperatur von Umgebungstemperatur bis 100 °C für 5 bis 20 Sekunden, wobei die Polyvinylphosphonsäure-Lösung teilweise mit einer wässrigen Base neutralisiert ist und auf einem pH-Wert von 2,5 bis 6,6 gehalten wird;
(c) Aufbringen einer fotoempfindlichen Schicht;
(d) Belichtender fotoempfindlichen Schicht mit einer geeigneten aktinischen Strahlung; und
(e) Entwickeln der belichteten Schicht in einem geeigneten Entwickler.

21. Verfahren nach Anspruch 20, dadurch gekennzeichnet, dass der Aluminiumträger im Schritt (a) des weiteren aufgeraut und anschließend oxidiert wird.

22. Verfahren nach Anspruch 20, dadurch gekennzeichnet, dass die fotoempfindliche Schicht des Schrittes (c) eine Diazoverbindung enthält, dass die aktinische Strahlung des Schrittes (d) im Wellenlängenbereich 300 bis 400 nm liegt und dass der Entwickler des Schrittes (e) ein wässriger Entwickler ist.

23. Verfahren zum Vorbereiten einer lithographischen Druckplatte, umfassend aufeinanderfolgende Schritte:
(a) Bereitstellen eines Metallträgers;
(b) Hydrophilien des Metallträgers durch eine Schritt, der im wesentlichen darin besteht, den Metallträger in Kontakt mit einer Lösung aus Polyvinylphosphonsäure in einem Lösungsmittel, das Wasser enthält, zu bringen bei einer Temperature im Bereich der Umgebungstemperatur bis 100 °C für 5 bis 20 Sekunden, wobei die Polyvinylphosphonsäurelösung mit einer wässrigen Base teilweise neutralisiert wird und auf einem pH-Wert von 2,5 bis 6,6 gehalten wird;
(c) Aufbringen einer fotoempfindlichen Schicht;
(d) Belichten derfotoempfindlichen Schicht mit einer geeigneten aktinischen Strahlung; und
(e) Entwickeln der belichteten Schicht in einem geeigneten Entwickler.

24. Verfahren nach Anspruch 23, dadurch gekennzeichnet, dass der Metallträger Aluminium ist, das des weiteren aufgeraut und des weiteren oxidiert wird.

## Revendications

1. Procédé de préparation d'une plaque de lithographie, comprenant les étapes successives consistant :
(a) à former un substrat d'un métal approprié ;
(b) à préparer une solution d'acide polyvinyl phosphonique en neutralisant partiellement une solution d'acide polyvinyl phosphonique dans un solvant comprenant de l'eau et une base aqueuse ;
(c) à rendre hydrophile le substrat par une étape consistant essentiellement à mettre ledit substrat en contact avec la solution de l'acide polyvinyl phosphonique partiellement neutralisée dans un solvant comprenant de l'eau, à une température allant de la température ambiante à environ 100 °C pendant environ 5 à 20 s, ladite solution d'acide polyvinyl phosphonique étant maintenue à un pH d'environ 2,5 à 6,6 ;
(d) à appliquer une couche photosensible ;
(e) à exposer ladite couche photosensible à un rayonnement actinique approprié ; et
(f) à développer ladite couche exposée dans un révélateur approprié.

2. Procédé selon la revendication 1, dans lequel ledit substrat est en aluminium ou en acier.

3. Procédé selon la revendication 1, dans lequel ledit substrat est en aluminium.

4. Procédé selon la revendication 1, dans lequel ladite solution polyvinyl phosphonique est maintenue à un pH d'environ 2,5 à 6.

5. Procédé selon la revendication 1, dans lequel ladite solution d'acide polyvinyl phosphonique est maintenue à un pH d'environ 2,5 à 5.

6. Procédé selon la revendication 1, dans lequel ladite base est choisie parmi l'hydroxyde de sodium, l'hydroxyde de potassium, l'hydroxyde d'ammonium, l'hydroxyde de calcium et l'hydroxyde de tétraméthylammonium.

7. Procédé selon la revendication 6, dans lequel ladite base est l'hydroxyde de sodium.

8. Procédé selon la revendication 1, dans lequel ladite mise en contact est effectuée à une température d'environ 38 à 93 °C (de 100 à 200 °F).

9. Procédé selon la revendication 1, dans lequel ladite mise en contact est effectuée à une température d'environ 60 à 79 °C (140 à 180 °F).

10. Procédé selon la revendication 1, dans lequel ladite couche photosensible comprend un composé photosensible de type positif.

11. Procédé selon la revendication 1, dans lequel ladite couche photosensible comprend un composé photosensible de type négatif.

12. Procédé selon la revendication 10, dans lequel ledit composé photosensible positif est un ester d'acide sulfonique dérivé d'un ortho-quinone diazide.

13. Procédé selon la revendication 11, dans lequel ledit composé photosensible négatif est un composé de type diazonium.

14. Procédé selon la revendication 13, dans lequel ledit composé de type diazonium est un produit de polycondensation du sulfate de 3-méthoxy-4-diazo diphényl amine et de l'éther de 4,4'-bisméthoxy méthyl-diphényle, précipité sous forme mésitylène d'un sulfonate.

15. Procédé selon la revendication 1, dans lequel ledit rayonnement actinique a une longueur d'onde de 300 à 400 nm.

16. Procédé selon la revendication 1, dans lequel ledit révélateur est un révélateur aqueux choisi parmi l'octyl monosulfate de sodium, le décyl monosulfate de potassium, le dodécyl monosulfate de lithium et leurs associations.

17. Procédé selon la revendication 1, dans lequel ledit substrat de métal dans l'étape (a) a en outre une surface rendue rugueuse.

18. Procédé selon la revendication 17, dans lequel ledit substrat rendu rugueux est ensuite oxydé.

19. Plaque de lithographie préparée selon le procédé décrit dans la revendication 1.

20. Procédé pour préparer une plaque de lithographie, comprenant les étapes successives consistant :
(a) à former un substrat d'aluminium ;
(b) à rendre hydrophile un substrat d'aluminium par une étape consistant essentiellement à mettre ledit substrat d'aluminium en contact avec une solution d'acide polyvinyl phosphonique dans un solvant comprenant de l'eau, à une température allant de la température ambiante à environ 100 °C pendant environ 5 à 20 s, ladite solution d'acide polyvinyl phosphonique ayant été partiellement neutralisée avec une base aqueuse, et étant maintenue à un pH d'environ 2,5 à 6,6 ;
(c) à appliquer une couche photosensible ;
(d) à exposer ladite couche photosensible à un rayonnement actinique approprié ; et
(e) à développer ladite couche exposée dans un révélateur approprié.

21. Procédé selon la revendication 20, dans lequel ledit substrat d'aluminium dans l'étape (a) est ensuite rendu rugueux et ultérieurement oxydé.

22. Procédé selon la revendication 20, dans lequel ladite couche photosensible de l'étape (c) comprend un composé de type diazonium, ledit rayonnement actinique de l'étape (d) ayant une longueur d'onde de 300 à 400 nm, et ledit révélateur de l'étape (e) étant un révélateur aqueux.

23. Procédé pour préparer une plaque de lithographie, comprenant les étapes successives consistant :
(a) à former un substrat de métal ;
(b) à rendre hydrophile le substrat de métal dans une étape consistant essentiellement à mettre ledit substrat de métal en contact avec une solution d'acide polyvinyl phosphonique dans un solvant comprenant de l'eau, à une température allant de la température ambiante jusqu'à environ 100 °C pendant environ 5 à 20 s, ladite solution d'acide polyvinyl phosphonique ayant été partiellement neutralisée avec une base aqueuse, et étant maintenue à un pH d'environ 2,5 à 6,6 ;
(c) à appliquer une couche photosensible ;
(d) à exposer ladite couche photosensible à un rayonnement actinique approprié ; et
(e) à développer ladite couche exposée dans un révélateur approprié.

24. Procédé selon la revendication 23, dans lequel ledit substrat de métal est en aluminium qui a été ensuite rendu rugueux et ultérieurement encore oxydé.
